(19) Europäisches Patentamt / European Patent Office / Office européen des brevets

(11) **EP 4 279 226 B1**

(12) **EUROPEAN PATENT SPECIFICATION**

(45) Date of publication and mention
of the grant of the patent:
**26.03.2025 Bulletin 2025/13**

(21) Application number: **22773912.5**

(22) Date of filing: **28.01.2022**

(51) International Patent Classification (IPC):
**G05D 1/00** *(2024.01)*   **B25J 9/16** *(2006.01)*
**B25J 19/00** *(2006.01)*   **B25J 13/00** *(2006.01)*
**A01D 34/00** *(2006.01)*

(52) Cooperative Patent Classification (CPC):
**G05D 1/0227; A01D 34/008; B25J 9/16;
B25J 13/00; B25J 19/00**

(86) International application number:
**PCT/CN2022/074590**

(87) International publication number:
**WO 2022/199250 (29.09.2022 Gazette 2022/39)**

(54) **SELF-PROPELLED DEVICE AND COLLISION DETECTION METHOD THEREOF**

SELBSTFAHRENDE VORRICHTUNG UND KOLLISIONSERKENNUNGSVERFAHREN DAFÜR

DISPOSITIF AUTOMOTEUR ET SON PROCÉDÉ DE DÉTECTION DE COLLISION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.03.2021 CN 202110316484**

(43) Date of publication of application:
**22.11.2023 Bulletin 2023/47**

(73) Proprietor: **Nanjing Chervon Industry Co., Ltd.
Nanjing, Jiangsu 211106 (CN)**

(72) Inventor: **WANG, Kang
Nanjing, Jiangsu 211106 (CN)**

(74) Representative: **Sun, Yiming
HUASUN Patent- und Rechtsanwälte
Friedrichstraße 33
80801 München (DE)**

(56) References cited:
CN-A- 109 049 006    CN-A- 109 397 283
CN-A- 112 405 523    CN-A- 112 405 523
CN-A- 112 405 524    CN-A- 112 405 524
US-A1- 2008 109 136

## Description

This application claims priority to Chinese Patent Application No. 202110316484.0 filed with the China National Intellectual Property Administration (CNIPA) on Mar. 25, 2021.

## TECHNICAL FIELD

The present application relates to a self-propelled apparatus and a collision detection method thereof.

## BACKGROUND

A self-propelled apparatus, for example, an intelligent mower, as an apparatus for mowing grass automatically, can autonomously move and finish mowing grass in a certain region without being operated by a user for a long time, which is intelligent and convenient, saves a labor cost, and is increasingly favored by users. When colliding with an obstacle, the self-propelled apparatus needs to perform a self-perception and perform corresponding obstacle avoidance operations. According to a conventional perception method, a double-layer housing structure is used, and a Hall sensor is mounted at the joint of two layers of housings. After a collision occurs, a relative displacement of the housings causes a Hall signal to change, thereby determining the occurrence of the collision. With this perception method, it is necessary to add a housing to the whole body or part of the self-propelled apparatus, which increases a production cost and the volume of the apparatus.

Other collision detection techniques in self-propelled apparatuses are known from the Chinese Patent Applications CN 112 405 523 A and CN 112 405 524 A.

## SUMMARY

The present application provides a collision detection method with a low cost and high accuracy and a corresponding self-propelled apparatus.

The present application adopts the technical solutions described below.

In a first aspect, the present application provides a collision detection method of a self-propelled apparatus. The self-propelled apparatus includes a self-propelled electric motor for driving wheels to rotate. The collision detection method includes: detecting a current of the self-propelled electric motor in real time and calculating a change rate of the current of the self-propelled electric motor; detecting a rotational speed of the self-propelled electric motor in real time and calculating a change rate of the rotational speed of the self-propelled electric motor; and determining, according to at least the change rate of the current and the change rate of the rotational speed, whether the self-propelled apparatus collides, wherein it is determined that the apparatus collides if the current increases to a respective extent while the rotational speed decreases to a respective extent.

Further, when the change rate of the current of the self-propelled electric motor increases to a first threshold and the change rate of the rotational speed of the self-propelled electric motor decreases to a second threshold, the value of a counter is increased, and when the value of the counter is greater than a third threshold, it is determined that the self-propelled apparatus collides.

Further, the collision detection method further includes: detecting acceleration of the self-propelled apparatus and calculating a change value of the acceleration; and adjusting the first threshold and the second threshold dynamically according to the change value of the acceleration.

Further, the first threshold is decreased and the second threshold is increased when the change value of the acceleration increases.

Further, the collision detection method further includes: detecting first acceleration of the self-propelled apparatus in an x-axis direction and second acceleration of the self-propelled apparatus in a y-axis direction; calculating a change value of the first acceleration and a change value of the second acceleration separately; acquiring a combined acceleration change value according to the change value of the first acceleration and the change value of the second acceleration; and determining that the self-propelled apparatus collides when the combined acceleration change value is greater than a fourth threshold.

Further, the collision detection method further includes: determining a direction of the collision according to the first acceleration and the second acceleration after the self-propelled apparatus collides.

Further, the collision detection method further includes: detecting acceleration of the self-propelled apparatus; calculating a change value of the acceleration when the change rate of the current of the self-propelled electric motor increases to a first threshold and the change rate of the rotational speed of the self-propelled electric motor decreases to a second threshold; and determining that the self-propelled apparatus collides if the change value of the acceleration is greater than a fourth threshold.

In a second aspect, the present application provides a self-propelled apparatus. The self-propelled apparatus includes: wheels configured to support the self-propelled apparatus and drive the self-propelled apparatus to walk; a self-propelled electric motor configured to drive the wheels to rotate so as to implement a self-propelled function; a current detection device configured to measure and calculate a current of the self-propelled electric motor in real time; a speed measurement device configured to measure and calculate a rotational speed of the self-propelled electric motor in real time; and a control module configured to determine whether the self-propelled apparatus collides. The control module calculates a change rate of the current according to the current measured and calculated by the current detection device, calculates a change rate of the rotational speed according to the rotational speed measured and calculated by the speed measurement device, and determines, according to at least the change rate of the current and the change rate of the rotational speed, whether the self-propelled apparatus collides, wherein it is determined that the apparatus collides if the current increases to a respective extent while the rotational speed decreases to a respective extent.

Further, the control module is further configured to: increase the value of a counter when the change rate of the current of the self-propelled electric motor increases to a first threshold and the change rate of the rotational speed of the self-propelled electric motor decreases to a second threshold; and determine that the self-propelled apparatus collides when the value of the counter is greater than a third threshold. Further, the self-propelled apparatus further includes an accelerometer configured to detect acceleration of the self-propelled apparatus.

Further, the control module is further configured to: calculate a change value of the acceleration of the self-propelled apparatus according to the acceleration detected by the accelerometer; and adjust the first threshold and the second threshold dynamically according to the change value of the acceleration.

Further, the control module is further configured to: acquire first acceleration of the self-propelled apparatus in an x-axis direction and second acceleration of the self-propelled apparatus in a y-axis direction from the accelerometer; calculate a change value of the first acceleration and a change value of the second acceleration separately; acquire a combined acceleration change value according to the change value of the first acceleration and the change value of the second acceleration; and determine that the self-propelled apparatus collides when the combined acceleration change value is greater than a fourth threshold.

Further, the control module determines a direction of the collision according to the first acceleration and the second acceleration after determining that the collision occurs.

Further, the self-propelled apparatus further includes an accelerometer configured to detect acceleration of the self-propelled apparatus, where the control module is further configured to: calculate a change value of the acceleration when the change rate of the current of the self-propelled electric motor increases to a first threshold and the change rate of the rotational speed of the self-propelled electric motor decreases to a second threshold; and determine that the self-propelled apparatus collides if the change value of the acceleration is greater than a fourth threshold.

Further, the self-propelled apparatus is an intelligent mower.

According to the present application, collision recognition with relatively high accuracy is implemented in conjunction with multiple parameters on the premise that it is unnecessary to provide an additional device. Thresholds and the parameters are adjusted such that the collision recognition is applicable to multiple tools and multiple working conditions.

## BRIEF DESCRIPTION OF DRAWINGS

FIG. 1 is a schematic diagram of a system of an intelligent mower according to an example of the present application;

FIG. 2A is a flowchart of a collision detection method according to an example of the present application;

FIG. 2B is a sub-flowchart of a collision detection method according to an example of the present application;

FIG. 3A is another sub-flowchart of a collision detection method according to an example of the present application;

FIG. 3B shows an example list of part of steps of the flowchart in FIG. 3A;

FIG. 4A is a graph showing the changes of the average values of current values within the different numbers of sampling points over time;

FIG. 4B is a graph showing the changes of the change rates of the currents of current values within the different numbers of sampling points over time;

FIG. 5 is a structural view of an intelligent mower according to another example of the present application; and

FIG. 6 is a flowchart of a collision detection method according to another example of the present application.

## DETAILED DESCRIPTION

Hereinafter, an intelligent mower is used as an example, and a collision detection method of a self-propelled apparatus is described in detail in conjunction with drawings.

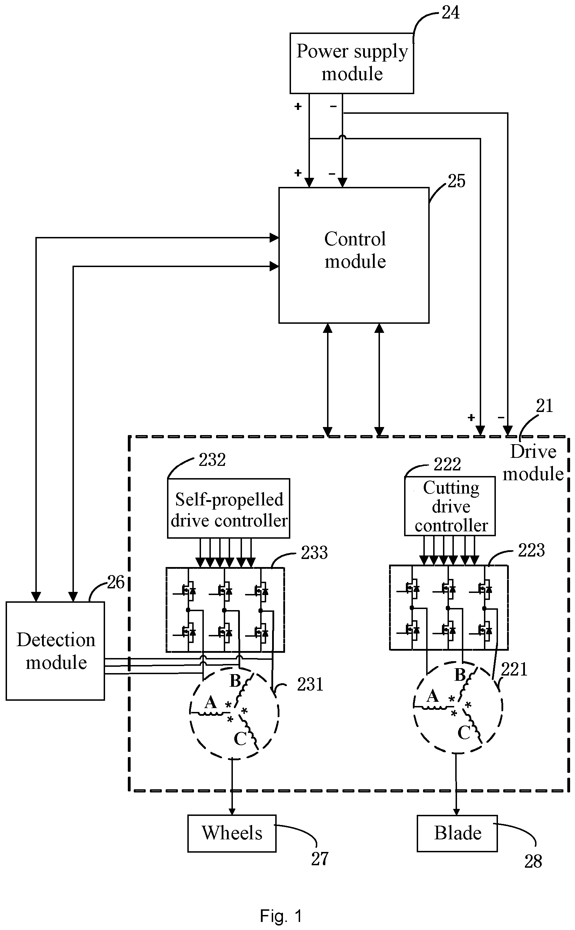

As shown in FIG. 1, an intelligent mower 100 includes a power supply module 24, a control module 25, a detection module 26, a drive module 21, wheels 27, and a blade 28. The drive module 21 includes a cutting drive controller 222 and the drive switch circuit 223 thereof, a cutting electric motor 221, a self-propelled drive controller 232 and the drive switch circuit 233 thereof, and a self-propelled electric motor 231. The cutting electric motor 221 is configured to drive a working assembly, such as the blade 28, to implement a cutting function. The self-propelled electric motor 231 is configured to drive the wheels 27 to rotate so as to implement a self-propelled function. When the intelligent mower collides with an obstacle or the like in a running direction during a walk, a rotational speed of the self-propelled electric motor 231 of the intelligent mower decreases while a current of the self-propelled electric motor 231 of the intelligent mower increases because the intelligent mower is hindered from walking. Based on this characteristic, the detection module 26 is connected to the self-propelled electric motor 231, detects the current of the self-propelled electric motor 231 and the rotational speed of the self-propelled electric motor 231 in real time, and sends the current of the self-propelled electric motor 231 and the rotational speed of the self-propelled electric motor 231 to the control module 25, and the control module 25 determines, according to the change of the current of the self-propelled electric motor 231 and the change of the rotational speed of the self-propelled electric motor 231, whether a collision occurs.

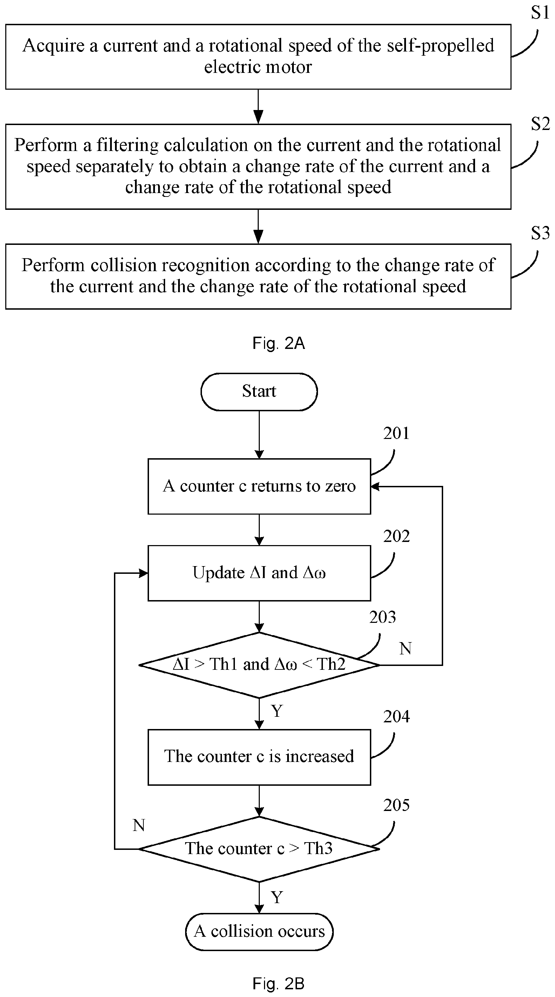

Referring to FIG. 2A, the basic steps of the collision detection method as one example are described below.

In S1, the current of the self-propelled electric motor 231 and the rotational speed of the self-propelled electric motor 231 are acquired.

In S2, a filtering calculation is performed on the current and the rotational speed separately so that a change rate of the current and a change rate of the rotational speed are obtained.

In S3, collision recognition is performed according to the change rate of the current and the change rate of the rotational speed.

Since collision detection is continuously performed during the running of the self-propelled apparatus, the preceding basic steps are also continuously performed in a cycle.

In step one S1, the detection module 26 acquires the current of the self-propelled electric motor 231 and the rotational speed of the self-propelled electric motor 231. For example, the detection module 26 includes a current detection resistor connected in series to the self-propelled electric motor 231 to sample a current flowing through the self-propelled electric motor 231. In an example, the self-propelled electric motor 231 is a sensored motor including a Hall sensor so that a real-time rotational speed of the self-propelled electric motor 231 can be calculated according to the frequency with which an output of the Hall sensor changes. In another example, the self-propelled electric motor 231 is a sensorless motor including a counter-electromotive force detection unit so that a real-time rotational speed of the self-propelled electric motor 231 can be calculated according to the frequency of a zero-crossing of the counter-electromotive force. The present application neither limits the type of the self-propelled electric motor 231 nor limits the manners in which the current of the self-propelled electric motor 231 and the rotational speed of the self-propelled electric motor 231 are measured and calculated. The detection module 26 samples the current of the self-propelled electric motor 231 and the rotational speed of the self-propelled electric motor 231 at a predetermined interval (for example, a sampling frequency is 20 Hz, and the predetermined interval is 50 ms). The detection module 26 is connected to the control module 25 and transmits the sampled current of the self-propelled electric motor 231 and the sampled rotational speed of the self-propelled electric motor 231 to the control module 25.

In step two S2, the control module 25 filters data of the latest n currents of the self-propelled electric motor 231 and data of the latest n rotational speeds of the self-propelled electric motor 231 to obtain the change rates of the two with the preset number n of sampling points. In an example, an example is provided in which first-order resistor-capacitor (RC) filtering is performed on the data of the currents, and the specific formula is as follows:

$$\sum_{i=t-n}^{t} I_i = \sum_{i=t-n-1}^{t-1} I_i - \frac{\sum_{i=t-n-1}^{t-1} I_i}{n} + I_t$$

where t denotes current time, n denotes the number of sampling points, $\sum_{i=t-n}^{t} I_i$ denotes the sum of accumulated sampling values of a current value I within the number n of sampling points at the current time t, $\sum_{i=t-n-1}^{t-1} I_i$ denotes the sum of accumulated sampling values of the current value I within the number n of sampling points at the previous time t - 1, It denotes the current value I at the current time t, and $\frac{\sum_{i=t-n-1}^{t-1} I_i}{n}$ denotes the sampling average value of the current value I within the number n of sampling points at the previous time t - 1. That is to say, in the process where time lapses, according to this filtering algorithm, the sampling average value within the number n of sampling points at the previous time is subtracted from the sum of the accumulated sampling values and the sampling value at the current time is added, and the calculation is performed over time according to this rule. In addition, a relative change rate $\Delta I$ of the current value I with the number n of sampling points may be calculated according to the sampling value at the current time and the sampling average value within the number n of sampling points at the previous time, and the specific formula is as follows:

$$\Delta I = \frac{I_t - \frac{\Sigma_{i=t-n-1}^{t-1} I_i}{n}}{\frac{\Sigma_{i=t-n-1}^{t-1} I_i}{n}};$$

where the preceding method is an example in which the data of the currents of the self-propelled electric motor 231 is processed through the first-order RC filtering, and the method may be applicable to processing the data of the rotational speeds of the self-propelled electric motor 231 so that a relative change rate $\Delta\omega$ of the rotational speed $\omega$ of the self-propelled electric motor 231 with the number n of sampling points is obtained. The preceding formulas and algorithms are merely examples, and the specific algorithms used in the filtering process are not limited in the present application.

In step three S3, the control module 25 performs the collision recognition according to the relative change rate of the current of the self-propelled electric motor 231 and the relative change rate of the rotational speed of the self-propelled electric motor 231. Specifically, some thresholds such as a first threshold and a second threshold may be preset in the control module 25, and a real-time relative change rate of the current of the self-propelled electric motor 231 and a real-time relative change rate of the rotational speed of the self-propelled electric motor 231 are compared with these thresholds. If the current increases to a certain extent while the rotational speed decreases to a certain extent, collision determination is performed. Specifically, in an example, a collision recognition algorithm may be shown in the flowchart in FIG. 2B. After the intelligent mower 100 is turned on, a counter c is initialized so that the initial value of the counter c is 0, as shown in step 201. During the running of the intelligent mower 100, the data of the currents of the self-propelled electric motor 231 and the data of the rotational speeds of the self-propelled electric motor 231 are continuously collected as described in S1. In addition, the change rate of the current and the change rate of the rotational speed are repeatedly calculated and updated as described in S2. That is to say, the change rate $\Delta I$ of the current and the change rate $\Delta\omega$ of the rotational speed are continuously updated in the cycle. As shown in step 202, each time a set of a new change rate $\Delta I$ of the current and a new change rate $\Delta\omega$ of the rotational speed are obtained, the determination is performed once. In step 203, it is determined whether the change rate $\Delta I$ of the current is greater than a first threshold Th1 and whether the change rate $\Delta\omega$ of the rotational speed is less than a second threshold Th2 (the second threshold Th2 is a negative value, so the more the rotational speed decreases, the smaller $\Delta\omega$). When the change rate $\Delta I$ of the current or the change rate $\Delta\omega$ of the rotational speed does not reach the threshold, that is, the change rate $\Delta I$ of the current is less than or equal to the first threshold Th1 or the change rate $\Delta\omega$ of the rotational speed is greater than or equal to the second threshold Th2, step 201 is performed where the counter c returns to zero and thus the next cycle is entered. If and only if both the change rate $\Delta I$ of the current and the change rate $\Delta\omega$ of the rotational speed reach the thresholds, that is, the change rate $\Delta I$ of the current is greater than the first threshold Th1 and the change rate $\Delta\omega$ of the rotational speed is less than the second threshold Th2, step 204 is performed where the value of the counter c is increased. After the value of the counter c is increased in step 204, step 205 is performed where it is determined whether the value of the counter c is greater than a third threshold Th3. When the value of the counter c is less than or equal to the third threshold Th3, step 202 is performed where the change rate $\Delta I$ of the current and the change rate $\Delta\omega$ of the rotational speed are updated and thus the next cycle is entered. When the value of the counter c is greater than the third threshold Th3, it is determined that the collision occurs. After the collision is recognized, the control module 25 may control, according to a post-collision strategy, the machine to run, which is not described in detail here. In this detection flow, the number of times the current increases and the number of times the rotational speed decreases are accumulated by the counter c so that false alarms are reduced and the accuracy of the collision detection is improved. In addition, since no additional device is provided, only the original parameters of the self-propelled electric motor 231 are used, which is very low in cost and easy to popularize.

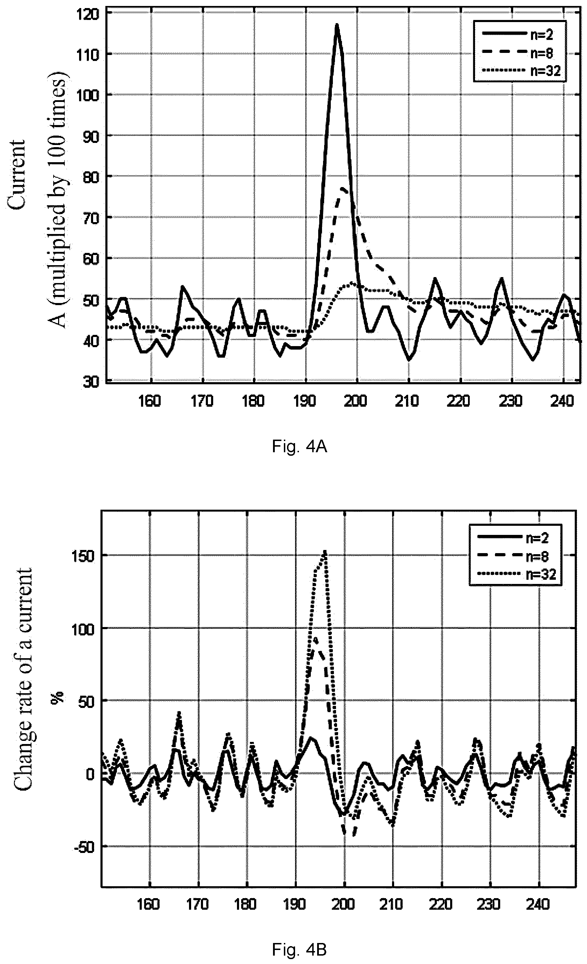

It is to be noted that the parameters such as the first threshold Th1, the second threshold Th2, the third threshold Th3, the number n of sampling points, and the amount of change of the counter c may be adjusted and changed according to different tools and different working conditions. When the tool is manufactured, these parameters may be determined through a large number of experiments and may be pre-stored in a control program or stored in a control program as variables. In addition, when the tool runs, the parameters may be adjusted in real time/dynamically according to real-time parameters during the running. For example, when walking normally on grass, the intelligent mower faces a greater frictional force than an intelligent sweeper used indoors. Correspondingly, the first threshold Th1 of the intelligent mower is higher and the second threshold Th2 of the intelligent mower is lower. For another example, the different numbers n of sampling points (for example, n refers to 2, 8, and 32 samples separately) are selected for filtering the current of the self-propelled electric motor 231 of the intelligent mower 100, and filtering results are shown in FIG. 4A and FIG. 4B. FIG. 4A is a graph showing the changes of the average values of current values I within the number n of sampling points over time when n is 2, 8, and 32 separately, and FIG. 4B is a graph showing the changes of the change rates $\Delta I$ of the currents within the number n of sampling points over time when n is 2, 8, and 32 separately. From experimental results in FIG. 4A and FIG. 4B, it can be seen that the larger the number n of sampling points, the slower a tracking effect is, that is, the more slowly the average value of the current value I within the number n of sampling points changes, but the more apparent an integration effect is, that is, the higher the change rate ΔI of the current within the number n of sampling points. In an experiment, the different numbers n (n is 2, 8, 16, and 32 separately) of sampling points are selected for filtering the rotational speed of the self-propelled electric motor 231 of the intelligent mower 100, the change of filtering results of the rotational speed is similar to the change of the filtering results of the current, and the details are not repeated here. In an implementation, the number of sampling points for detecting the change of the current and the number of sampling points for detecting the change of the rotational speed need not be the same as each other and may be separately selected in conjunction with degrees to which the changes are apparent and the amounts of calculations. For example, through tests on the intelligent mower 100, 32 is selected as the number of sampling points for detecting the change of the current, that is, n = 32, and 16 is selected as the number of sampling points for detecting the change of the rotational speed, that is, n = 16.

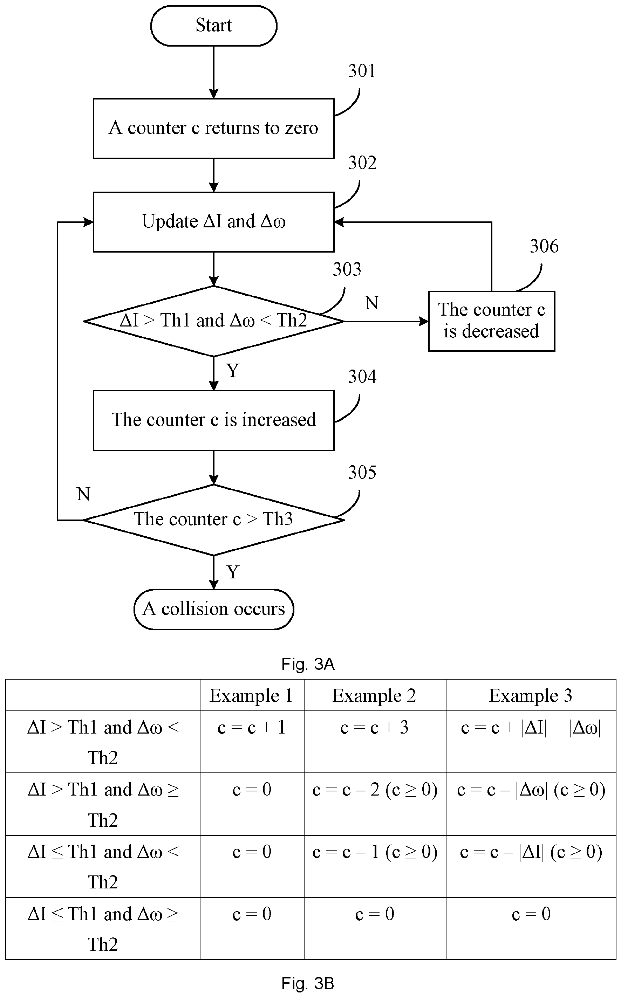

In an example, the counter c is not only used for simply recording the number of times both a real-time change rate ΔI of the current and a real-time change rate Δω of the rotational speed reach the thresholds, but also capable of reflecting the proportion of the change rate ΔI of the current and the proportion of the change rate Δω of the rotational speed and/or the magnitude of the specific value of the change rate ΔI of the current and the magnitude of the specific value of the change rate Δω of the rotational speed through the adjustment of the amount of change of the counter c, as shown in FIG. 3A and FIG. 3B. FIG. 3A differs from FIG. 2B in that when the change rate ΔI of the current or the change rate Δω of the rotational speed does not reach the threshold, that is, the change rate ΔI of the current is less than or equal to the first threshold Th1 or the change rate Δω of the rotational speed is greater than or equal to the second threshold Th2, step 306 is performed where the counter c is decreased and thus a new cycle is entered. Specifically, for the amount of change of an increase of the counter c in step 304 and the amount of change of the decrease of the counter c in step 306, reference may be made to examples in the table in FIG. 3B. Example 1 shows the flow described in FIG. 2B. In example 2, when both the change rate ΔI of the current and the change rate Δω of the rotational speed reach the thresholds, that is, the change rate ΔI of the current is greater than the first threshold Th1 and the change rate Δω of the rotational speed is less than the second threshold Th2, the increase of the counter c in step 304 is 3; when the change rate ΔI of the current is less than or equal to the first threshold Th1 and the change rate Δω of the rotational speed is less than the second threshold Th2, the counter c is decreased by 1 (the counter c is greater than or equal to 0) in step 306; when the change rate ΔI of the current is greater than the first threshold Th1 and the change rate

Δω of the rotational speed is greater than or equal to the second threshold Th2, the counter c is decreased by 2 (the counter c is greater than or equal to 0) in step 306; and when neither the change rate ΔI of the current nor the change rate Δω of the rotational speed reaches the threshold, the counter c returns to zero. Therefore, the amount of change of the counter c is set so that the weight of the change rate of the current and the weight of the change rate of the rotational speed can be adjusted. In example 3, the amount of change of the counter c is changeable and reflects the magnitudes of the change rates. For example, when both the change rate ΔI of the current and the change rate Δω of the rotational speed reach the thresholds, that is, the change rate ΔI of the current is greater than the first threshold Th1 and the change rate Δω of the rotational speed is less than the second threshold Th2, the increase of the counter c in step 304 is equal to the sum of the absolute value of the change rate ΔI of the current and the absolute value of the change rate Δω of the rotational speed; when the change rate ΔI of the current is less than or equal to the first threshold Th1 and the change rate Δω of the rotational speed is less than the second threshold Th2, the counter c is decreased by the absolute value of the change rate ΔI of the current in step 306 (the counter c is greater than or equal to 0); when the change rate ΔI of the current is greater than the first threshold Th1 and the change rate Δω of the rotational speed is greater than or equal to the second threshold Th2, the counter c is decreased by the absolute value of the change rate Δω of the rotational speed in step 306 (the counter c is greater than or equal to 0); and when neither the change rate ΔI of the current nor the change rate Δω of the rotational speed reaches the threshold, the counter c returns to zero. Therefore, the amount of change of the counter c is set so that the magnitudes of the change rates can be accumulated. In addition to the preceding examples, there are more methods for setting the amount of change of the counter c, for example, the combination of example 2 with example 3, which are not described in detail here. The amount of change of the counter c is customized so that this collision detection method is more applicable to the different tools and/or working conditions and improves the accuracy of the collision detection.

In an example, values of the first threshold Th1 and values of the second threshold Th2 are different when the intelligent mower 100 is in different running directions. Typically, when the intelligent mower 100 moves forward, the absolute value of the first threshold Th1 and the absolute value of the second threshold Th2 (a negative value) are maximized and used for detecting a collision from the direction in which the intelligent mower 100 moves forward; when the intelligent mower 100 turns left or right, the absolute value of the first threshold Th1 and the absolute value of the second threshold Th2 (the negative value) are the second largest values and used for detecting a collision from the left or right side of the intelligent mower 100; and when the intelligent mower 100 moves backward, the absolute value of the first threshold Th1 and the absolute value of the second threshold Th2 (the negative value) are minimized and used for detecting a collision from the direction in which the intelligent mower 100 moves backward. Therefore, when switching the running direction, the intelligent mower 100 also switches to a corresponding first threshold Th1 and a corresponding second threshold Th2 at the same time. Since the rotational speeds and currents of the self-propelled electric motor 231 are different at different running speeds and change rates caused by the same collision force are different, the value of the first threshold Th1 and the value of the second threshold Th2 are also changed at the different running speeds. Therefore, the intelligent mower 100 uses a corresponding first set of a first threshold Th1 and a second threshold Th2 at a first running speed and uses a corresponding second set of a first threshold Th1' and a second threshold Th2' at a second running speed, where the first threshold Th1 in the first set is greater than the first threshold Th1' in the second set, and the second threshold Th2 in the first set is less than the second threshold Th2' in the second set when the first running speed is higher than the second running speed. The thresholds are dynamically adjusted in real time according to a running condition so that the accuracy of the collision detection is higher and omissions and erroneous determination are reduced.

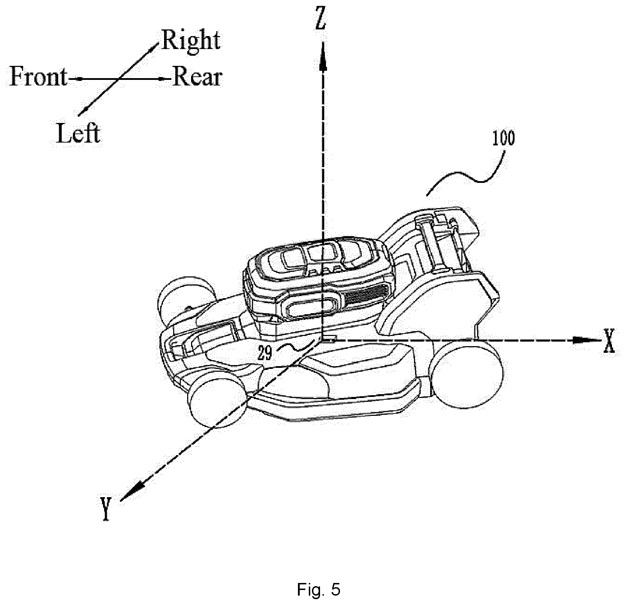

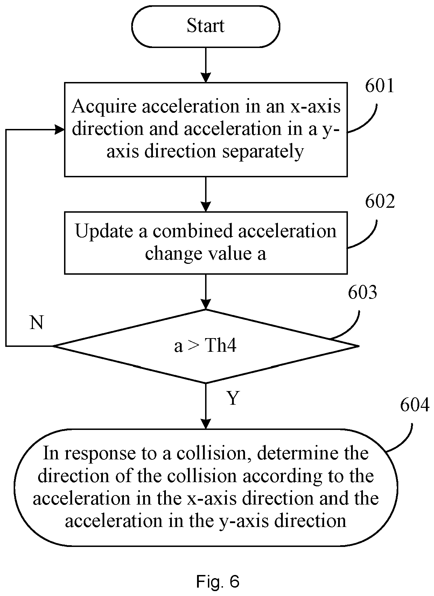

With the preceding method, the collision from the running direction of the intelligent mower 100 may be detected according to the current of the self-propelled electric motor 231 and the rotational speed of the self-propelled electric motor 231. In order to detect a collision from a non-running direction, for example, a side collision on the intelligent mower 100 when the intelligent mower 100 moves forward, the intelligent mower 100 may further include an accelerometer 29 and use a reading of the accelerometer 29 for assisting in determining whether the collision occurs and determining the direction of the collision. As shown in FIG. 5, for ease of description, the x-axis, y-axis, and z-axis of the accelerometer 29, the front and rear direction of the intelligent mower 100, and the left and right direction of the intelligent mower 100 are defined in FIG. 5. The specific flow in which the collision is detected with the accelerometer is shown in FIG. 6. In step 601, the accelerometer 29 is used for acquiring acceleration of the intelligent mower 100 in the x-axis direction and acceleration of the intelligent mower 100 in the y-axis direction separately. In fact, a common accelerometer is a three-axis accelerometer, for example, a three-axis accelerometer with a microelectromechanical system (MEMS), which may provide acceleration in the x-axis direction, the y-axis direction, and the z-axis direction. However, here, it is considered that most of collisions on an apparatus during a walk are from the front and rear direction and the left and right direction, and only the acceleration in the x-axis direction and the acceleration in the y-axis direction may be acquired. In step 602, a combined acceleration change value a is obtained by methods such as median filtering and/or average filtering. Specifically, the difference between a value of the acceleration in the x-axis direction at present and the average value or the median value of the acceleration in the x-axis direction within the number n of sampling points may be defined as $\Delta x$, the difference between a value of the acceleration in the y-axis direction at present and the average value or the median value of the acceleration in the y-axis direction within the number n of sampling points may be defined as $\Delta y$, and the combined acceleration change value a is defined, where $a = \Delta x^2 + \Delta y^2$ and the combined acceleration change value a represents the superimposition of changes of acceleration in the two axes. It is to be understood that other filtering and combination calculation methods are also possible. In step 603, it is determined through comparison whether the combined acceleration change value a is greater than a fourth threshold Th4, where when a is less than or equal to the fourth threshold Th4, it is determined that no collision occurs, and step 601 is performed and the cycle is continued, and when a is greater than the fourth threshold Th4, step 604 is performed in which it is determined that the collision has occurred and the direction of an object causing the collision is determined according to the acceleration in the x-axis direction and the acceleration in the y-axis direction. For example, when the acceleration in the x-axis direction is positive, it is determined that the self-propelled apparatus is struck by an object located in the reverse direction of the x-axis, that is, a front object; and when the acceleration in the x-axis direction is negative, it is determined that the self-propelled apparatus is struck by an object located in the forward direction of the x-axis, that is, a rear object. When the acceleration in the y-axis direction is positive, it is determined that the self-propelled apparatus is struck by an object located in the reverse direction of the y-axis, that is, a left object; and when the acceleration in the y-axis direction is negative, it is determined that the self-propelled apparatus is struck by an object located in the forward direction of the y-axis, that is, a right object.

The collision detection through the acceleration may be used as a supplement to the collision detection through the current of the self-propelled electric motor 231 and the rotational speed of the self-propelled electric motor 231 in the preceding example. That is, when the collision is detected by the current and rotational speed method, it is considered that the collision occurs in the running direction; and when the collision is not detected by the current and rotational speed method, if the collision is detected by the acceleration method, it is considered that the collision occurs and the direction of the collision is calculated with the acceleration. In addition, the preceding two sets of determination criteria may be superimposed so that the accuracy of the collision detection is improved and the false alarms are reduced. Specifically, when the change rate $\Delta I$ of the current of the self-propelled electric motor 231 is greater than the first threshold Th1 and the change rate $\Delta\omega$ of the rotational speed of the self-propelled electric motor 231 is less than the second threshold Th2, the combined acceleration change value a of the intelligent mower 100 is calculated, where when the combined acceleration change value a is greater than the fourth threshold Th4, it is determined that the intelligent mower 100 collides, and when the combined acceleration change value a is less than or equal to the fourth threshold Th4, it is considered that no collision occurs. Alternatively, when the combined acceleration change value a of the intelligent mower 100 is greater than the fourth threshold Th4, the change rate $\Delta I$ of the current of the self-propelled electric motor 231 is verified, where if the change rate $\Delta I$ of the current is greater than the first threshold Th1, it is determined that the intelligent mower 100 collides, and if the change rate $\Delta I$ of the current is less than or equal to the first threshold Th1, it is considered that no collision occurs. Alternatively, when the combined acceleration change value a of the intelligent mower 100 is greater than the fourth threshold Th4, the change rate $\Delta\omega$ of the rotational speed of the self-propelled electric motor 231 is verified, where if the change rate $\Delta\omega$ of the rotational speed is less than the second threshold Th2, it is determined that the intelligent mower 100 collides, and if the change rate $\Delta\omega$ of the rotational speed is greater than the second threshold Th2, it is considered that no collision occurs.

In an example, the first threshold Th1 and the second threshold Th2 may be dynamically adjusted in real time according to the combined acceleration change value a. For example, with a first combined acceleration change value a1, the intelligent mower 100 uses a corresponding first set of a first threshold Th1 and a second threshold Th2, and with a second combined acceleration change value a2, the intelligent mower 100 uses a corresponding second set of a first threshold Th1' and a second threshold Th2', where the first threshold Th1 in the first set is less than the first threshold Th1' in the second set, and the second threshold Th2 in the first set is greater than the second threshold Th2' in the second set when the first combined acceleration change value a1 is greater than the second combined acceleration change value a2. Alternatively, it is defined that $f(\Delta I, \Delta\omega, a) = \alpha\Delta I + \beta\Delta\omega + \gamma a$, where $f(\Delta I, \Delta\omega, a)$ denotes a collision state amount, the value of the collision state amount varies with the following parameters: $\Delta I$-the change rate of the current, $\Delta\omega$-the change rate of the rotational speed, and a-the combined acceleration change value, and $\alpha$, $\beta$, and $\gamma$ are coefficients corresponding to the parameters, where $\alpha$ is a positive value, $\beta$ is a negative value, and $\gamma$ is a positive value. When the collision state amount $f(\Delta I, \Delta\omega, a)$ reaches a certain threshold, it is determined that the intelligent mower 100 collides. The current and rotational speed method and the acceleration method are combined so that the shortcomings of a single method are compensated and the self-propelled apparatus can recognize the collision from the running direction and the collision from the non-running direction, thereby improving a collision recognition rate. Multiple verifications are performed and the thresholds are adjusted in time so that the accuracy of the collision detection is improved. The self-propelled apparatus in the present application is not limited to the intelligent mower and may be an intelligent sweeper, an intelligent snow thrower, or the like.

## Claims

1. A collision detection method of a self-propelled apparatus (100), wherein the self-propelled apparatus (100) comprises a self-propelled electric motor (231) for driving wheels (27) to rotate, and the collision detection method comprises:

   detecting a current of the self-propelled electric motor (231) in real time and calculating a change rate ($\Delta I$) of the current of the self-propelled electric motor (231);
   detecting a rotational speed of the self-propelled electric motor (231) in real time and calculating a change rate ($\Delta\omega$) of the rotational speed of the self-propelled electric motor (231); **characterized in that**
   determining, according to at least the change rate ($\Delta I$) of the current and the change rate ($\Delta\omega$) of the rotational speed, whether the self-propelled apparatus (100) collides, wherein it is determined that the apparatus (100) collides if the current increases to a respective extent while the rotational speed decreases to a respective extent.

2. The collision detection method according to claim 1, wherein:

   a value of a counter (c) is set to zero upon turning on the apparatus (100);
   a filtering calculation is performed on the current and on the rotational speed separately to obtain the change rate ($\Delta I$) of the current of the self-propelled electric motor (231) and the change rate ($\Delta\omega$) of the rotational speed of the self-propelled electric motor (231); and
   when the change rate ($\Delta I$) of the current of the self-propelled electric motor (231) is below a first threshold (Th1, Th1') and the change rate ($\Delta\omega$) of the rotational speed of the self-propelled electric motor (231) is above a second threshold (Th2, Th2'), the value of the counter (c) is set to zero; and
   when the change rate ($\Delta I$) of the current of the self-propelled electric motor (231) increases to the first threshold (Th1, Th1') and the change rate ($\Delta\omega$) of the rotational speed of the self-propelled electric motor (231) decreases to the second threshold (Th2, Th2'), the value of the counter (c) is increased, and when the value of the counter (c) is greater than a third threshold (Th3), it is determined that the self-propelled apparatus (100) collides.

3.  The collision detection method according to claim 2, further comprising:

    detecting acceleration of the self-propelled apparatus (100) and calculating a change value of the acceleration; and
    adjusting the first threshold (Th1, Th1') and the second threshold (Th2, Th2') dynamically according to the change value of the acceleration.

4.  The collision detection method according to claim 3, wherein the first threshold (Th1, Th1') is decreased and the second threshold (Th2, Th2') is increased when the change value of the acceleration increases.

5.  The collision detection method according to claim 1, further comprising:

    detecting first acceleration of the self-propelled apparatus (100) in an x-axis direction and second acceleration of the self-propelled apparatus (100) in a y-axis direction;
    calculating a change value of the first acceleration and a change value of the second acceleration separately; and
    acquiring a combined acceleration change value according to the change value of the first acceleration and the change value of the second acceleration; and
    determining that the self-propelled apparatus (100) collides when the combined acceleration change value is greater than a fourth threshold (Th4).

6.  The collision detection method according to claim 5, further comprising:
    determining a direction of the collision according to the first acceleration and the second acceleration after the self-propelled apparatus (100) collides.

7.  The collision detection method according to claim 1, further comprising:

    detecting acceleration of the self-propelled apparatus (100);
    calculating a change value of the acceleration when the change rate ($\Delta$I) of the current of the self-propelled electric (231) motor increases to a first threshold (Th1, Th1') and the change rate ($\Delta\omega$) of the rotational speed of the self-propelled electric motor (231) decreases to a second threshold (Th2, Th2'); and
determining that the self-propelled apparatus (100) collides if the change value of the acceleration is greater than a fourth threshold (Th4).

8.  A self-propelled apparatus (100), comprising:

    wheels (27) configured to support the self-propelled apparatus (100) and drive the self-propelled apparatus (100) to walk;
    a self-propelled electric motor (231) configured to drive the wheels (27) to rotate so as to implement a self-propelled function;
    a current detection device configured to measure and calculate a current of the self-propelled electric motor (231) in real time;
    a speed measurement device configured to measure and calculate a rotational speed of the self-propelled electric motor (231) in real time; and
    a control module (25) configured to determine whether the self-propelled apparatus (100) collides;
    wherein the control module (25) is configured to calculate a change rate ($\Delta$I) of the current according
    to the current measured and calculated by the current detection device, to calculate a change rate ($\Delta\omega$) of the rotational speed according to the rotational speed measured and calculated by the speed measurement device, **characterized in that**
    the control module (25) is configured to determine, according to at least the change rate ($\Delta$I) of the current and the change rate ($\Delta\omega$) of the rotational speed, whether the self-propelled apparatus (100) collides, wherein it is determined that the apparatus (100) collides if the current increases to a respective extent while the rotational speed decreases to a respective extent.

9.  The self-propelled apparatus (100) according to claim 8, wherein the control module (25) is further configured to:

    set a value of a counter (c) to zero upon turning on the apparatus (100);
    perform a filtering calculation on the current and on the rotational speed separately to obtain the change rate ($\Delta$I) of the current of the self-propelled electric motor (231) and the change rate ($\Delta\omega$) of the rotational speed of the self-propelled electric motor (231); and
    set the value of the counter (c) to zero when the change rate ($\Delta$I) of the current of the self-propelled electric motor (231) is below a first threshold (Th1, Th1') and the change rate ($\Delta\omega$) of the rotational speed of the self-propelled electric motor (231) is above a second threshold (Th2, Th2'); and

increase the value of the counter (c) when the change rate ($\Delta I$) of the current of the self-propelled electric motor (231) increases to the first threshold (Th1, Th1') and the change rate ($\Delta \omega$) of the rotational speed of the self-propelled electric motor (231) decreases to the second threshold (Th2, Th2'); and determine that the self-propelled apparatus (100) collides when the value of the counter (c) is greater than a third threshold (Th3).

10. The self-propelled apparatus (100) according to claim 9, further comprising an accelerometer (29) configured to detect acceleration of the self-propelled apparatus (100).

11. The self-propelled apparatus (100) according to claim 10, wherein the control module (25) is further configured to: calculate a change value of the acceleration of the self-propelled apparatus (100) according to the acceleration detected by the accelerometer (29); and adjust the first threshold (Th1, Th1') and the second threshold (Th2, Th2') dynamically according to the change value of the acceleration.

12. The self-propelled apparatus (100) according to claim 10, wherein the control module (25) is further configured to: acquire first acceleration of the self-propelled apparatus (100) in an x-axis direction and second acceleration of the self-propelled apparatus (100) in a y-axis direction from the accelerometer (29); calculate a change value of the first acceleration and a change value of the second acceleration separately; acquire a combined acceleration change value according to the change value of the first acceleration and the change value of the second acceleration; and determine that the self-propelled apparatus (100) collides when the combined acceleration change value is greater than a fourth threshold (Th4).

13. The self-propelled apparatus (100) according to claim 12, wherein the control module (25) determines a direction of the collision according to the first acceleration and the second acceleration after determining that the collision occurs.

14. The self-propelled apparatus (100) according to claim 8, further comprising an accelerometer (29) configured to detect acceleration of the self-propelled apparatus (100), wherein the control module (25) is further configured to: calculate a change value of the acceleration when the change rate ($\Delta I$) of the current of the self-propelled electric motor (231) increases to a first threshold (Th1, Th1') and the

change rate ($\Delta \omega$) of the rotational speed of the self-propelled electric motor (231) decreases to a second threshold (Th2, Th2'); and determine that the self-propelled apparatus (100) collides if the change value of the acceleration is greater than a fourth threshold (Th4).

15. The self-propelled apparatus (100) according to claim 8, wherein the self-propelled apparatus (100) is an intelligent mower (100).

**Patentansprüche**

1. Ein Verfahren zur Kollisionsdetektion einer selbstfahrenden Vorrichtung (100), wobei die selbstfahrende Vorrichtung (100) einen selbstfahrenden Elektromotor (231) umfasst, der dazu konfiguriert ist, Räder (27) anzutreiben, um eine Rotation zu ermöglichen, und das Kollisionsdetektionsverfahren umfasst:

   das Erfassen eines Stroms des selbstfahrenden Elektromotors (231) in Echtzeit und das Berechnen einer Änderungsrate ($\Delta I$) des Stroms des selbstfahrenden Elektromotors (231); das Erfassen einer Drehzahl des selbstfahrenden Elektromotors (231) in Echtzeit und das Berechnen einer Änderungsrate ($\Delta \omega$) der Drehzahl des selbstfahrenden Elektromotors (231); **dadurch gekennzeichnet, dass** basierend auf mindestens der Änderungsrate ($\Delta I$) des Stroms und der Änderungsrate ($\Delta \omega$) der Drehzahl bestimmt wird, ob die selbstfahrende Vorrichtung (100) kollidiert, wobei eine Kollision der Vorrichtung (100) festgestellt wird, wenn der Strom auf ein bestimmtes Maß ansteigt, während die Drehzahl auf ein bestimmtes Maß abfällt.

2. Das Kollisionsdetektionsverfahren nach Anspruch 1, wobei:

   ein Zählerwert (c) beim Einschalten der Vorrichtung (100) auf null gesetzt wird; eine Filterberechnung sowohl für den Strom als auch für die Drehzahl separat durchgeführt wird, um die Änderungsrate ($\Delta I$) des Stroms des selbstfahrenden Elektromotors (231) und die Änderungsrate ($\Delta \omega$) der Drehzahl des selbstfahrenden Elektromotors (231) zu erhalten; und wenn die Änderungsrate ($\Delta I$) des Stroms des selbstfahrenden Elektromotors (231) unter einem ersten Schwellenwert (Th1, Th1') liegt und die Änderungsrate ($\Delta \omega$) der Drehzahl des selbstfahrenden Elektromotors (231) über einem zweiten Schwellenwert (Th2, Th2') liegt, wird der Zählerwert (c) auf null gesetzt;

und wenn die Änderungsrate ($\Delta I$) des Stroms des selbstfahrenden Elektromotors (231) auf den ersten Schwellenwert (Th1, Th1') ansteigt und die Änderungsrate ($\Delta\omega$) der Drehzahl des selbstfahrenden Elektromotors (231) auf den zweiten Schwellenwert (Th2, Th2') abfällt, wird der Zählerwert (c) erhöht, und wenn der Zählerwert (c) größer als ein dritter Schwellenwert (Th3) ist, wird festgestellt, dass die selbstfahrende Vorrichtung (100) kollidiert.

3. Das Kollisionsdetektionsverfahren nach Anspruch 2, ferner umfassend:

   das Erfassen der Beschleunigung der selbstfahrenden Vorrichtung (100) und das Berechnen eines Änderungswerts der Beschleunigung; und

   das dynamische Anpassen des ersten Schwellenwerts (Th1, Th1') und des zweiten Schwellenwerts (Th2, Th2') gemäß dem Änderungswert der Beschleunigung.

4. Das Kollisionsdetektionsverfahren nach Anspruch 3, wobei der erste Schwellenwert (Th1, Th1') verringert und der zweite Schwellenwert (Th2, Th2') erhöht wird, wenn der Änderungswert der Beschleunigung ansteigt.

5. Das Kollisionsdetektionsverfahren nach Anspruch 1, ferner umfassend:

   das Erfassen einer ersten Beschleunigung der selbstfahrenden Vorrichtung (100) in einer x-Achsenrichtung und einer zweiten Beschleunigung der selbstfahrenden Vorrichtung (100) in einer y-Achsenrichtung;

   das separate Berechnen eines Änderungswerts der ersten Beschleunigung und eines Änderungswerts der zweiten Beschleunigung;

   das Ermitteln eines kombinierten Beschleunigungsänderungswerts basierend auf dem Änderungswert der ersten Beschleunigung und dem Änderungswert der zweiten Beschleunigung;

   und das Bestimmen, dass die selbstfahrende Vorrichtung (100) kollidiert, wenn der kombinierte Beschleunigungsänderungswert größer als ein vierter Schwellenwert (Th4) ist.

6. Das Kollisionsdetektionsverfahren nach Anspruch 5, ferner umfassend:
   das Bestimmen einer Kollisionsrichtung basierend auf der ersten Beschleunigung und der zweiten Beschleunigung nach Feststellung der Kollision der selbstfahrenden Vorrichtung (100).

7. Das Kollisionsdetektionsverfahren nach Anspruch 1, ferner umfassend:

   das Erfassen der Beschleunigung der selbstfahrenden Vorrichtung (100);

   das Berechnen eines Änderungswerts der Beschleunigung, wenn die Änderungsrate ($\Delta I$) des Stroms des selbstfahrenden Elektromotors (231) auf den ersten Schwellenwert (Th1, Th1') ansteigt und die Änderungsrate ($\Delta\omega$) der Drehzahl des selbstfahrenden Elektromotors (231) auf den zweiten Schwellenwert (Th2, Th2') abfällt;

   und das Bestimmen, dass die selbstfahrende Vorrichtung (100) kollidiert, wenn der Änderungswert der Beschleunigung größer als ein vierter Schwellenwert (Th4) ist.

8. Eine selbstfahrende Vorrichtung (100), umfassend:

   Räder (27), die dazu konfiguriert sind, die selbstfahrende Vorrichtung (100) zu stützen und deren Bewegung zu ermöglichen;

   einen selbstfahrenden Elektromotor (231), der dazu konfiguriert ist, die Räder (27) anzutreiben, um eine selbstfahrende Funktion zu implementieren;

   eine Stromeinrichtung zur Echtzeitmessung und -berechnung des Stroms des selbstfahrenden Elektromotors (231);

   eine Drehzahlmesseinrichtung zur Echtzeitmessung und Berechnung der Drehzahl des selbstfahrenden Elektromotors (231); und

   ein Steuerungsmodul (25), das dazu konfiguriert ist, festzustellen, ob die selbstfahrende Vorrichtung (100) kollidiert;

   das Steuerungsmodul (25) ist dazu konfiguriert, eine Änderungsrate ($\Delta I$) des Stroms basierend auf dem durch die Stromeinrichtung gemessenen und berechneten Strom zu berechnen sowie eine Änderungsrate ($\Delta\omega$) der Drehzahl basierend auf der durch die Drehzahlmesseinrichtung gemessenen und berechneten Drehzahl zu berechnen;

   **dadurch gekennzeichnet, dass**

   das Steuerungsmodul (25) dazu konfiguriert ist, basierend auf mindestens der Änderungsrate ($\Delta I$) des Stroms und der Änderungsrate ($\Delta\omega$) der Drehzahl zu bestimmen, ob die selbstfahrende Vorrichtung (100) kollidiert, wobei eine Kollision festgestellt wird, wenn der Strom auf ein bestimmtes Maß ansteigt, während die Drehzahl auf ein bestimmtes Maß abfällt.

9. Die selbstfahrende Vorrichtung (100) nach Anspruch 8, wobei das Steuerungsmodul (25) ferner dazu konfiguriert ist,

   eine Wertsetzung eines Zählers (c) auf null zu setzen, wenn die Vorrichtung (100) eingeschaltet wird,

eine Filterberechnung für den Strom und die Drehzahl separat durchzuführen, um die Änderungsrate (ΔI) des Stroms des selbstfahrenden Elektromotors (231) und die Änderungsrate (Δω) der Drehzahl des selbstfahrenden Elektromotors (231) zu erhalten, und

den Wert des Zählers (c) auf null zu setzen, wenn die Änderungsrate (ΔI) des Stroms des selbstfahrenden Elektromotors (231) unter einem ersten Schwellenwert (Th1, Th1') liegt und die Änderungsrate (Δω) der Drehzahl des selbstfahrenden Elektromotors (231) über einem zweiten Schwellenwert (Th2, Th2') liegt, und

den Wert des Zählers (c) zu erhöhen, wenn die Änderungsrate (ΔI) des Stroms des selbstfahrenden Elektromotors (231) auf den ersten Schwellenwert (Th1, Th1') ansteigt und die Änderungsrate (Δω) der Drehzahl des selbstfahrenden Elektromotors (231) auf den zweiten Schwellenwert (Th2, Th2') abfällt, und zu bestimmen, dass die selbstfahrende Vorrichtung (100) kollidiert, wenn der Wert des Zählers (c) größer als ein dritter Schwellenwert (Th3) ist.

10. Die selbstfahrende Vorrichtung (100) nach Anspruch 9, ferner umfassend:
einen Beschleunigungsmesser (29), der dazu konfiguriert ist, die Beschleunigung der selbstfahrenden Vorrichtung (100) zu erfassen.

11. Die selbstfahrende Vorrichtung (100) nach Anspruch 10, wobei das Steuerungsmodul (25) ferner dazu konfiguriert ist: einen Änderungswert der Beschleunigung der selbstfahrenden Vorrichtung (100) basierend auf der durch den Beschleunigungsmesser (29) erfassten Beschleunigung zu berechnen; und den ersten Schwellenwert (Th1, Th1') und den zweiten Schwellenwert (Th2, Th2') dynamisch entsprechend dem Änderungswert der Beschleunigung anzupassen.

12. Die selbstfahrende Vorrichtung (100) nach Anspruch 10, wobei das Steuerungsmodul (25) ferner dazu konfiguriert ist: eine erste Beschleunigung der selbstfahrenden Vorrichtung (100) in einer x-Achsen-Richtung und eine zweite Beschleunigung der selbstfahrenden Vorrichtung (100) in einer y-Achsen-Richtung durch den Beschleunigungsmesser (29) zu erfassen; einen Änderungswert der ersten Beschleunigung und einen Änderungswert der zweiten Beschleunigung separat zu berechnen; einen kombinierten Beschleunigungsänderungswert basierend auf dem Änderungswert der ersten Beschleunigung und dem Änderungswert der zweiten Beschleunigung zu ermitteln; und zu bestimmen, dass die selbstfahrende Vorrichtung (100) kollidiert, wenn der kombinierte Beschleunigungsänderungswert größer als ein vierter Schwellenwert (Th4) ist.

13. Die selbstfahrende Vorrichtung (100) nach Anspruch 12, wobei das Steuerungsmodul (25) nach Feststellung der Kollision der selbstfahrenden Vorrichtung (100) die Richtung der Kollision basierend auf der ersten Beschleunigung und der zweiten Beschleunigung bestimmt.

14. Die selbstfahrende Vorrichtung (100) nach Anspruch 8, ferner umfassend:
einen Beschleunigungsmesser (29), der dazu konfiguriert ist, die Beschleunigung der selbstfahrenden Vorrichtung (100) zu erfassen, wobei das Steuerungsmodul (25) ferner dazu konfiguriert ist: einen Änderungswert der Beschleunigung zu berechnen, wenn die Änderungsrate (ΔI) des Stroms des selbstfahrenden Elektromotors (231) auf den ersten Schwellenwert (Th1, Th1') ansteigt und die Änderungsrate (Δω) der Drehzahl des selbstfahrenden Elektromotors (231) auf den zweiten Schwellenwert (Th2, Th2') abfällt; und zu bestimmen, dass die selbstfahrende Vorrichtung (100) kollidiert, wenn der Änderungswert der Beschleunigung größer als ein vierter Schwellenwert (Th4) ist.

15. Die selbstfahrende Vorrichtung (100) nach Anspruch 8, wobei die selbstfahrende Vorrichtung (100) ein intelligenter Mäher (100) ist.

**Revendications**

1. Un procédé de détection de collision d'un appareil autopropulsé (100), l'appareil autopropulsé (100) comprenant un moteur électrique autopropulsé (231) conçu pour entraîner des roues (27) en rotation, le procédé de détection de collision comprenant :

la détection en temps réel d'un courant du moteur électrique autopropulsé (231) et le calcul d'un taux de variation (ΔI) du courant du moteur électrique autopropulsé (231) ;
la détection en temps réel d'une vitesse de rotation du moteur électrique autopropulsé (231) et le calcul d'un taux de variation (Δω) de la vitesse de rotation du moteur électrique autopropulsé (231) ;
**caractérisé en ce que**
il est déterminé, sur la base d'au moins le taux de variation (ΔI) du courant et le taux de variation (Δω) de la vitesse de rotation, si l'appareil autopropulsé (100) entre en collision, la collision de l'appareil (100) étant déterminée si le courant augmente dans une certaine mesure tandis que la vitesse de rotation diminue dans une certaine mesure.

2. Le procédé de détection de collision selon la revendication 1, dans lequel :

une valeur d'un compteur (c) est initialisée à zéro lors de la mise sous tension de l'appareil (100) ;
un calcul de filtrage est effectué séparément sur le courant et sur la vitesse de rotation afin d'obtenir le taux de variation ($\Delta I$) du courant du moteur électrique autopropulsé (231) et le taux de variation ($\Delta \omega$) de la vitesse de rotation du moteur électrique autopropulsé (231) ;
et lorsque le taux de variation ($\Delta I$) du courant du moteur électrique autopropulsé (231) est inférieur à un premier seuil (Th1, Th1') et que le taux de variation ($\Delta \omega$) de la vitesse de rotation du moteur électrique autopropulsé (231) est supérieur à un deuxième seuil (Th2, Th2'), la valeur du compteur (c) est remise à zéro ;
et lorsque le taux de variation ($\Delta I$) du courant du moteur électrique autopropulsé (231) atteint le premier seuil (Th1, Th1') et que le taux de variation ($\Delta \omega$) de la vitesse de rotation du moteur électrique autopropulsé (231) diminue jusqu'au deuxième seuil (Th2, Th2'), la valeur du compteur (c) est incrémentée, et si la valeur du compteur (c) est supérieure à un troisième seuil (Th3), il est déterminé que l'appareil autopropulsé (100) est entré en collision.

3. Le procédé de détection de collision selon la revendication 2, comprenant en outre :

la détection de l'accélération de l'appareil autopropulsé (100) et le calcul d'une valeur de variation de l'accélération ;
et l'ajustement dynamique du premier seuil (Th1, Th1') et du deuxième seuil (Th2, Th2') en fonction de la valeur de variation de l'accélération.

4. Le procédé de détection de collision selon la revendication 3, dans lequel le premier seuil (Th1, Th1') est diminué et le deuxième seuil (Th2, Th2') est augmenté lorsque la valeur de variation de l'accélération augmente.

5. Le procédé de détection de collision selon la revendication 1, comprenant en outre :

la détection d'une première accélération de l'appareil autopropulsé (100) dans une direction de l'axe x et d'une deuxième accélération de l'appareil autopropulsé (100) dans une direction de l'axe y ;

le calcul séparé d'une valeur de variation de la première accélération et d'une valeur de variation de la deuxième accélération ;
l'obtention d'une valeur de variation combinée de l'accélération en fonction de la valeur de variation de la première accélération et de la valeur de variation de la deuxième accélération ;
et la détermination que l'appareil autopropulsé (100) entre en collision lorsque la valeur de variation combinée de l'accélération est supérieure à un quatrième seuil (Th4).

6. Le procédé de détection de collision selon la revendication 5, comprenant en outre :
la détermination d'une direction de la collision en fonction de la première accélération et de la deuxième accélération après la détection de la collision de l'appareil autopropulsé (100).

7. Le procédé de détection de collision selon la revendication 1, comprenant en outre :

la détection de l'accélération de l'appareil autopropulsé (100) ;
le calcul d'une valeur de variation de l'accélération lorsque le taux de variation ($\Delta I$) du courant du moteur électrique autopropulsé (231) atteint un premier seuil (Th1, Th1') et que le taux de variation ($\Delta \omega$) de la vitesse de rotation du moteur électrique autopropulsé (231) diminue jusqu'à un deuxième seuil (Th2, Th2') ;
et la détermination que l'appareil autopropulsé (100) entre en collision si la valeur de variation de l'accélération est supérieure à un quatrième seuil (Th4).

8. Un appareil autopropulsé (100), comprenant :

des roues (27) configurées pour supporter l'appareil autopropulsé (100) et lui permettre de se déplacer ;
un moteur électrique autopropulsé (231) configuré pour entraîner les roues (27) en rotation afin de réaliser une fonction autopropulsée ;
un dispositif de détection de courant configuré pour mesurer et calculer en temps réel un courant du moteur électrique autopropulsé (231) ;
un dispositif de mesure de vitesse configuré pour mesurer et calculer en temps réel une vitesse de rotation du moteur électrique autopropulsé (231) ;
et un module de commande (25) configuré pour déterminer si l'appareil autopropulsé (100) entre en collision ;
le module de commande (25) est configuré pour calculer un taux de variation ($\Delta I$) du courant en fonction du courant mesuré et calculé par le dispositif de détection de courant, ainsi que pour calculer un taux de variation ($\Delta\omega$) de la vitesse de rotation en fonction de la vitesse de rotation mesurée et calculée par le dispositif de mesure de vitesse ;

**caractérisé en ce que**

le module de commande (25) est configuré pour déterminer, sur la base d'au moins le taux de variation ($\Delta I$) du courant et le taux de variation ($\Delta\omega$) de la vitesse de rotation, si l'appareil autopropulsé (100) entre en collision, la collision de l'appareil (100) étant déterminée si le courant augmente dans une certaine mesure tandis que la vitesse de rotation diminue dans une certaine mesure.

9. L'appareil autopropulsé (100) selon la revendication 8, dans lequel le module de commande (25) est en outre configuré pour :

mettre la valeur d'un compteur (c) à zéro lors de la mise sous tension de l'appareil (100) ; effectuer un calcul de filtrage séparément sur le courant et sur la vitesse de rotation afin d'obtenir le taux de variation ($\Delta I$) du courant du moteur électrique autopropulsé (231) et le taux de variation ($\Delta\omega$) de la vitesse de rotation du moteur électrique autopropulsé (231) ; mettre la valeur du compteur (c) à zéro lorsque le taux de variation ($\Delta I$) du courant du moteur électrique autopropulsé (231) est inférieur à un premier seuil (Th1, Th1') et que le taux de variation ($\Delta\omega$) de la vitesse de rotation du moteur électrique autopropulsé (231) est supérieur à un deuxième seuil (Th2, Th2') ; incrémenter la valeur du compteur (c) lorsque le taux de variation ($\Delta I$) du courant du moteur électrique autopropulsé (231) atteint le premier seuil (Th1, Th1') et que le taux de variation ($\Delta\omega$) de la vitesse de rotation du moteur électrique autopropulsé (231) diminue jusqu'au deuxième seuil (Th2, Th2') ; et déterminer que l'appareil autopropulsé (100) entre en collision lorsque la valeur du compteur (c) est supérieure à un troisième seuil (Th3).

10. L'appareil autopropulsé (100) selon la revendication 9, comprenant en outre : un accéléromètre (29) configuré pour détecter l'accélération de l'appareil autopropulsé (100).

11. L'appareil autopropulsé (100) selon la revendication 10, dans lequel le module de commande (25) est en outre configuré pour : calculer une valeur de variation de l'accélération de l'appareil autopropulsé (100) en fonction de l'accélération détectée par l'accéléromètre (29) ; et ajuster dynamiquement le premier seuil (Th1, Th1') et le deuxième seuil (Th2, Th2') en fonction de la valeur de variation de l'accélération.

12. L'appareil autopropulsé (100) selon la revendication 10, dans lequel le module de commande (25) est en outre configuré pour : acquérir une première accélération de l'appareil autopropulsé (100) dans une direction de l'axe x et une deuxième accélération de l'appareil autopropulsé (100) dans une direction de l'axe y à partir de l'accéléromètre (29) ; calculer séparément une valeur de variation de la première accélération et une valeur de variation de la deuxième accélération ; obtenir une valeur de variation combinée de l'accélération en fonction de la valeur de variation de la première accélération et de la valeur de variation de la deuxième accélération ; et déterminer que l'appareil autopropulsé (100) entre en collision lorsque la valeur de variation combinée de l'accélération est supérieure à un quatrième seuil (Th4).

13. L'appareil autopropulsé (100) selon la revendication 12, dans lequel le module de commande (25) détermine la direction de la collision en fonction de la première accélération et de la deuxième accélération après avoir déterminé qu'une collision s'est produite.

14. L'appareil autopropulsé (100) selon la revendication 8, comprenant en outre :
un accéléromètre (29) configuré pour détecter l'accélération de l'appareil autopropulsé (100), dans lequel le module de commande (25) est en outre configuré pour : calculer une valeur de variation de l'accélération lorsque le taux de variation ($\Delta I$) du courant du moteur électrique autopropulsé (231) atteint un premier seuil (Th1, Th1') et que le taux de variation ($\Delta\omega$) de la vitesse de rotation du moteur électrique autopropulsé (231) diminue jusqu'à un deuxième seuil (Th2, Th2') ; et déterminer que l'appareil autopropulsé (100) entre en collision si la valeur de variation de l'accélération est supérieure à un quatrième seuil (Th4).

15. L'appareil autopropulsé (100) selon la revendication 8, dans lequel l'appareil autopropulsé (100) est une tondeuse intelligente (100).

Fig. 1

S1

Acquire a current and a rotational speed of the self-propelled electric motor

S2

Perform a filtering calculation on the current and the rotational speed separately to obtain a change rate of the current and a change rate of the rotational speed

S3

Perform collision recognition according to the change rate of the current and the change rate of the rotational speed

Fig. 2A

Start

201

A counter c returns to zero

202

Update $\Delta I$ and $\Delta \omega$

203

$\Delta I >$ Th1 and $\Delta \omega <$ Th2    N

Y

204

The counter c is increased

205

N    The counter c > Th3

Y

A collision occurs

Fig. 2B

Fig. 3A

| | Example 1 | Example 2 | Example 3 |
|---|---|---|---|
| $\Delta I > Th1$ and $\Delta\omega <$ Th2 | $c = c + 1$ | $c = c + 3$ | $c = c + |\Delta I| + |\Delta\omega|$ |
| $\Delta I > Th1$ and $\Delta\omega \geq$ Th2 | $c = 0$ | $c = c - 2\ (c \geq 0)$ | $c = c - |\Delta\omega|\ (c \geq 0)$ |
| $\Delta I \leq Th1$ and $\Delta\omega <$ Th2 | $c = 0$ | $c = c - 1\ (c \geq 0)$ | $c = c - |\Delta I|\ (c \geq 0)$ |
| $\Delta I \leq Th1$ and $\Delta\omega \geq$ Th2 | $c = 0$ | $c = 0$ | $c = 0$ |

Fig. 3B

Fig. 4A

Fig. 4B

Fig. 5

Start

Acquire acceleration in an x-axis
direction and acceleration in a y-
axis direction separately

601

Update a combined acceleration
change value a

602

a > Th4

603

N

Y

In response to a collision, determine the
direction of the collision according to the
acceleration in the x-axis direction and the
acceleration in the y-axis direction

604

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110316484
- CN 112405523 A
- CN 112405524 A